# EUROPEAN PATENT SPECIFICATION

(11) **EP 3 582 594 B1**
(45) Date of publication and mention of the grant of the patent: **22.11.2023**
(21) Application number: 19180021.8
(22) Date of filing: 13.06.2019
(51) Int. Cl.: H05K 5/02, H05K 7/14

(54) **MODULE LOCKING APPARATUS, MODULE, AND ELECTRICAL EQUIPMENT**
MODULVERRIEGELUNGSVORRICHTUNG, MODUL UND ELEKTRISCHE AUSRÜSTUNG
APPAREIL DE VERROUILLAGE DE MODULE, MODULE ET ÉQUIPEMENT ÉLECTRIQUE

(30) Priority: 13.06.2018 CN 201810609961
(43) Date of publication of application: 18.12.2019
(73) Proprietor: Huawei Digital Power Technologies Co., Ltd., Shenzhen, 518043 (CN)
(72) Inventor: FAN, Guohua, Shenzhen, Guangdong 518129 (CN); HU, Xiong, Shenzhen, Guangdong 518129 (CN); SONG, Dingnan, Shenzhen, Guangdong 518129 (CN)
(74) Representative: Maiwald GmbH

(56) References cited:
- CN-B- 102 573 375
- US-A1- 2012 161 599
- US-A1- 2012 162 956
- US-A1- 2013 044 440
- US-A1- 2013 094 156
- US-A1- 2013 108 358
- US-A1- 2015 029 654

## Description

### TECHNICAL FIELD

This application relates to the field of communications technologies, and in particular, to a module locking apparatus, a module, and electrical equipment.

### BACKGROUND

In an existing communications cabinet, a communication power module is usually installed in a subrack inside the cabinet. When the communication power module is assembled or used, the communication power module usually needs to be pulled out of or pushed into the subrack. For ease of pulling out or pushing in the module, an ejector lever structure is usually designed on a panel of the module. After the module is inserted into the subrack, a fixing device is used to fix the module onto the subrack. Power density of a communications product is increasing, and utilization of product space in the module is increasingly high, and therefore an ejector lever needs to occupy less space, and have a more reliable fixing structure, a simpler assembly method, and an aesthetically attractive appearance.
US 2013/044440 A1 describes locking systems for fitting and securing modules in a housing includes at least one module.
US 2013 / 094156 A1 describes systems with a power supply unit that includes a sidewall, an end wall, a resilient latch, and a block. The end wall is connected to the sidewall.
CN 102 573 375 B1, US 2013/108358 A1, US 2012/162956 A1, US 2015/029654 A1, US 2012/161599 A1 all describe systems and methods for locking assemblies.

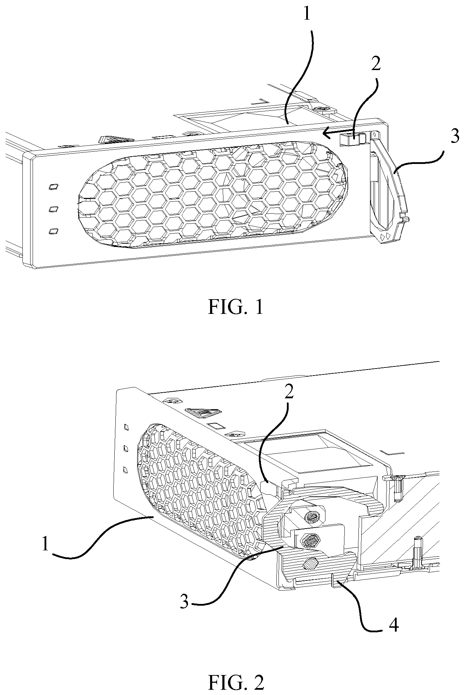

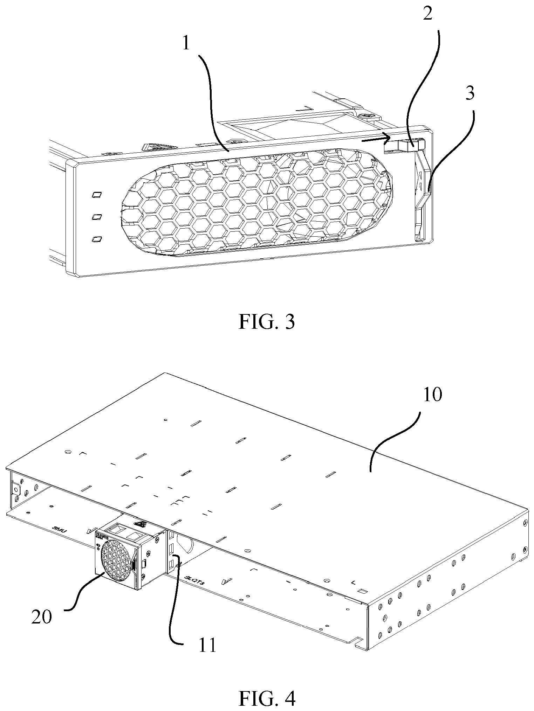

When a common module 1 is inserted into a cabinet, as shown in FIG. 1, a slider 2 on a panel of the module 1 is pressed to the left (in a direction indicated by an arrow in FIG. 1), an ejector lever 3 is pulled out, the module 1 is inserted into the cabinet, and then the ejector lever 3 is pushed in. As shown in FIG. 2, the module 1 is stuck in the cabinet by using a protrusion 4 disposed on the ejector lever 3. Finally, as shown in FIG. 3, the slider 2 is pressed to the right (in a direction indicated by an arrow in FIG. 3), to lock the ejector lever 3 and the module 1. When the module 1 needs to be pulled out, the slider 2 is pressed to the left, the ejector lever 3 is pulled out, and the module 1 is pulled out. However, when this method is used, the fastener for locking the module 1 needs to occupy space of the module 1, and consequently an effective area of a panel is reduced. In addition, when the foregoing locking structure is used, actions such as pressing the slider 2 and pulling the ejector lever 3 need to be performed, and the operations are relatively complex.

### SUMMARY

This application provides a module locking apparatus, a module, and electrical equipment, to facilitate locking of a module and reduce an area occupied by a locking apparatus on a panel of the module.

According to a first aspect, a module locking apparatus is provided, configured to lock a module onto a cabinet. The locking apparatus includes a casing and a supporting base that serves as a supporting apparatus, where the casing covers the supporting base, and space for accommodating main moving components of the locking apparatus is formed between the supporting base and the casing. The moving components include a tongue, an elastic component, and an ejector lever, where the tongue is located between the supporting base and the casing; one end of the tongue is rotatably connected to the supporting base, and the other end of the tongue is a free end; and a hook configured to engage with the cabinet is disposed on the free end. When the module is inserted into the cabinet, the module is locked by using the hook. During hook installation, the hook needs to extend out of the casing to engage with the cabinet, and the hook is pushed by the installed elastic component to engage with the cabinet. The elastic component is configured to drive the hook to be exposed out of the casing and engage with the cabinet, so that the hook can lock the module inside the cabinet when coordinating with the cabinet. Unlocking is implemented by using the ejector lever. The ejector lever is rotatably connected to the supporting base, and can press the tongue to rotate in a direction away from the casing. When being rotated to a first specified position, the ejector lever presses the tongue to rotate to a position in which the tongue is disengaged from the cabinet, thereby implementing unlocking.

According to the foregoing technical solution, the elastic component is used to push the hook to lock the module and the cabinet together, and to implement unlocking, only the ejector lever needs to be pulled to press the hook down. It can be learned from the foregoing description that the operations during using of the module locking apparatus provided in the present application are simple: Only the ejector lever needs to be pulled to implement unlocking, and the module is pushed into the cabinet to implement locking. In addition, when this structure is used, the tongue, the elastic component, and the ejector lever are all disposed on a side wall of the module, and only a part of the ejector lever is exposed out of a panel of the module. Compared with a module locking structure in the prior art, in this structure, an area occupied on the panel is reduced.

A specific structure of the tongue includes a rotating shaft and a connecting plate connected to the rotating shaft. The rotating shaft is rotatably connected to the supporting base, and the hook is disposed at an end of the connecting plate away from the rotating shaft. The installed rotating shaft coordinates with the supporting base to make the tongue rotate relative to the supporting base, and the connecting plate is installed to generate a specific distance between the hook and the rotating shaft, ensuring a specific rotation distance for the hook when the tongue rotates, to lock onto and unlock from the cabinet.

The elastic component is configured to push the tongue to rotate and enable the hook on the tongue to engage with the cabinet. The elastic component may be elastic components of different structure types. For example, the elastic component is a rotary spring. The rotary spring is sleeved on the rotating shaft of the tongue, and two ends of the rotary spring press against the supporting base and the connecting plate, respectively, to push the tongue to rotate and provide force for the hook to engage with the cabinet. Alternatively, the elastic component may be an elastic sheet. One end of the elastic sheet is provided with a bent structure, and correspondingly, a mounting base is disposed on the supporting base. The bent structure may be clamped on the mounting base, to fasten the elastic sheet onto the supporting base. The other end of the elastic sheet is a free end, and the free end presses against a surface, facing the supporting base, of the connecting plate, so that the connecting plate can be pushed to rotate in a direction away from the supporting base. Certainly, it should be understood that the elastic component may be a common elastic component different from the rotary spring and the elastic sheet, such as a compression spring or a rubber spring.

To ensure that the ejector lever can be locked when not being used, the bent structure on the elastic sheet is connected to an elastic protrusion that coordinates with the ejector lever. When the ejector lever is rotated to a second specified position, the ejector lever disengages from the tongue, and the ejector lever engages with the elastic protrusion, so that the ejector lever is fixed. The second specified position is a position in which the ejector lever is located when the ejector lever does not push the tongue.

A surface, facing away from the supporting base, of the connecting plate is a pressing surface that coordinates with the ejector lever, and the pressing surface is a surface pressed when the ejector lever pushes the tongue to rotate. The pressing surface faces away from the supporting base, and the pressing surface is disposed in an inclined manner opposite to a first surface, facing the supporting base, of the connecting plate. A vertical distance between the pressing surface and the first surface gradually increases in a direction away from the rotating shaft. In this way, when the ejector lever is rotated, an effect of pushing the tongue to rotate can be improved.

The ejector lever is a C-shaped ejector lever, and two ends of the ejector lever are a first end and a second end, respectively. The first end is used for pressing the pressing surface; and when the ejector lever is rotated to the second specified position, both the first end and the second end of the ejector lever are located in a notch, and a middle part of the ejector lever is exposed outside a side face that is of the supporting base and that is perpendicular to the casing. The exposed part makes it convenient to pull the ejector lever to rotate.

To more conveniently pull the ejector lever to rotate, an antiskid protrusion is disposed on the middle part of the ejector lever.

During specific installation, to improve the effect of driving, by the ejector lever, the tongue to rotate, a rotation direction of the ejector lever is perpendicular to a rotation direction of the tongue.

For ease of exposing the hook, a through hole that coordinates with the hook is disposed in the casing during installation of the casing. Pushed by the elastic component, the hook is exposed out of the through hole. When the ejector lever pushes the tongue, the hook moves back into the through hole.

According to a second aspect, a module is provided. The module includes a module body and the locking apparatus, according to any implementation of the first aspect, fixedly connected to the module body.

According to the foregoing technical solution, the elastic component is used to push the hook to lock the module and the cabinet together, and to implement unlocking, only the ejector lever needs to be pulled to press the hook down. It can be learned from the foregoing description that the operations during using of the module locking apparatus provided in the present application are simple: Only the ejector lever needs to be pulled to implement unlocking, and the module is pushed into the cabinet to implement locking. In addition, when this structure is used, the tongue, the elastic component, and the ejector lever are all disposed on a side wall of the module, and only a part of the ejector lever is exposed out of a panel of the module. Compared with a module locking structure in the prior art, in this structure, an area occupied on the panel is reduced.

During specific assembly, the module further includes an outer casing covering the module body. The supporting base and the side wall of the module body are of an integrated structure, and the casing and the outer casing of the module body are of an integrated structure. In this way, the locking apparatus can be directly formed on the module body.

According to a third aspect, electrical equipment is provided. The electrical equipment includes a cabinet and the module inserted into the cabinet, where a slot that coordinates with the hook is disposed in the cabinet.

According to the foregoing technical solution, the elastic component is used to push the hook to lock the module and the cabinet together, and to implement unlocking, only the ejector lever needs to be pulled to press the hook down. It can be learned from the foregoing description that the operations during using of the module locking apparatus provided in the present application are simple: Only the ejector lever needs to be pulled to implement unlocking, and the module is pushed into the cabinet to implement locking. In addition, when this structure is used, the tongue, the elastic component, and the ejector lever are all disposed on a side wall of the module, and only a part of the ejector lever is exposed out of a panel of the module. Compared with a module locking structure in the prior art, in this structure, an area occupied on the panel is reduced.

### BRIEF DESCRIPTION OF DRAWINGS

FIG. 1 is a schematic diagram of inserting a module into a cabinet in the prior art;
FIG. 2 is a schematic diagram of locking a module in a cabinet by using an ejector lever in the prior art;
FIG. 3 is a schematic structural diagram of locking an ejector lever for a module by using a slider in the prior art;
FIG. 4 is a schematic assembly diagram of a module and a cabinet according to an embodiment of this application;
FIG. 5 is a schematic exploded view of a module according to an embodiment of this application;
FIG. 6 is a schematic exploded view of a locking apparatus according to an embodiment of this application;
FIG. 7 is a schematic diagram of an internal structure of a locking apparatus according to an embodiment of this application;
FIG. 8 is a schematic exploded view of an internal structure of a locking apparatus according to an embodiment of this application;
FIG. 9 is a schematic structural diagram of a supporting base according to an embodiment of this application;
FIG. 10 is a schematic structural diagram of an elastic sheet according to an embodiment of this application;
FIG. 11a is a schematic structural diagram of a tongue according to an embodiment of this application;
FIG. 11b is a section view of a tongue according to an embodiment of this application;
FIG. 12 is a schematic structural diagram of an ejector lever according to an embodiment of this application;
FIG. 13a to FIG. 13c are schematic diagrams of coordination between a locking apparatus and a cabinet when an ejector lever has not been rotated according to an embodiment of this application;
FIG. 14a and FIG. 14b are schematic diagrams of coordination between a locking apparatus and a cabinet when an ejector lever is rotated according to an embodiment of this application; and
FIG. 15a and FIG. 15b are schematic diagrams of coordination between a locking apparatus and a cabinet when an ejector lever is rotated to a first specified position according to an embodiment of this application.

### DESCRIPTION OF EMBODIMENTS

To make the objectives, technical solutions, and advantages of the present application clearer, the following further describes the present application in detail with reference to the accompanying drawings. Apparently, the described embodiments are merely some rather than all of the embodiments of the present application. Embodiments of the invention are defined by the independent claim and preferred embodiments are defined by the dependent claims.

To facilitate understanding of a locking apparatus for a module 20 provided in the embodiments of this application, an application scenario of the locking apparatus provided in the embodiments of this application is first described. The locking module 20 is applied to electrical equipment. As shown in FIG. 4, the electrical equipment includes a cabinet 10, and a plurality of sockets 11 are disposed in the cabinet 10. A module 20 is inserted in each socket 11, and the locking apparatus provided in the embodiments of this application is configured to lock different modules 20 in the cabinet 10 of the electrical equipment. The locking apparatus is disposed on the module 20, a slot that coordinates with the locking apparatus is disposed in the cabinet 10, and the module 20 is locked in the cabinet 10 through coordination between the locking apparatus and the slot. The module 20 may be a common module 20 in the prior art, such as a power module 20, a communication module 20, and other modules with different functions.

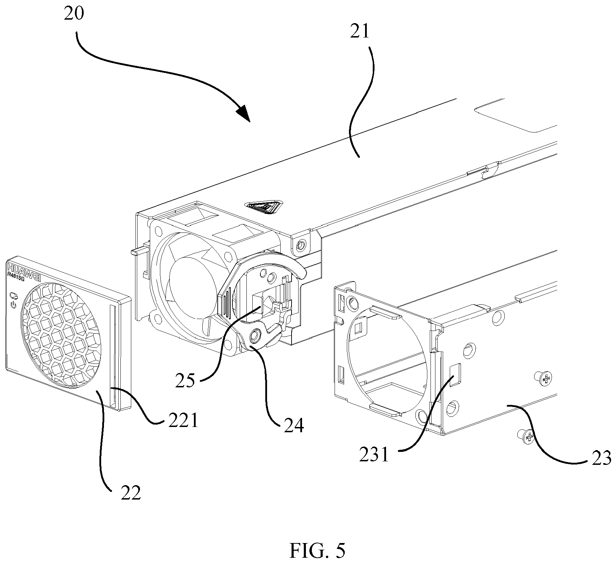

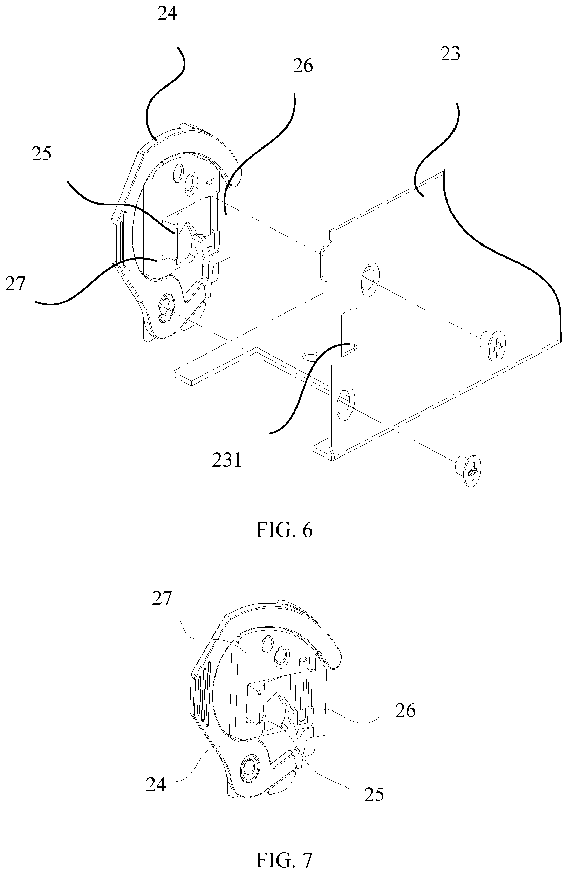

To resolve a prior-art problem that locking and unlocking by using a locking apparatus on a module 20 are complex, the embodiments of this application provide the locking apparatus for the module 20. Both FIG. 5 and FIG. 6 are referred to. FIG. 5 is a schematic assembly diagram of the module 20 and the locking apparatus, and FIG. 6 is a schematic structural diagram of the locking module 20. First, referring to FIG. 6, the locking apparatus includes a supporting base 27 and a casing 23, and the supporting base 27 and the casing 23 form a supporting component for supporting moving components of the locking apparatus. Also referring to FIG. 5, when the locking apparatus is disposed on the module 20, the supporting base 27 and the casing 23 of the locking apparatus may be implemented by using a side wall and an outer casing of the module 20, respectively. In this case, the supporting base 27 of the locking apparatus is the side wall of the module 20, and the casing 23 of the locking apparatus is the outer casing of the module 20.

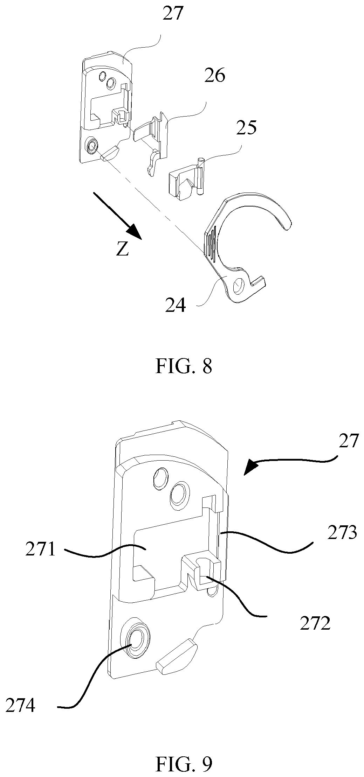

Still referring to FIG. 6, the moving components of the locking apparatus provided in the embodiments of this application include a tongue 25, an elastic component, and an ejector lever 24, and the tongue 25, the elastic component, and the ejector lever 24 are disposed in space formed after the casing 23 is covered on the supporting base 27. When the tongue 25, the elastic component, and the ejector lever 24 are specifically installed, refer to FIG. 7 and FIG. 8. FIG. 7 shows a status when the tongue 25, the elastic component, and the ejector lever 24 are disposed on the supporting base 27, and FIG. 8 is a schematic exploded view when the three components are assembled with the supporting base 27. It can be seen from FIG. 7 that, during installation of the tongue 25, one end of the tongue 25 is rotatably connected to the supporting base 27, and the other end is a free end. A hook is disposed on the free end, and the hook is configured to engage with a side wall of the socket 11 in the cabinet 10 for coordination. The tongue 25 has two working statuses when being rotated: One is that the hook is engaged with the side wall of the socket 11 when the module 20 is locked, and the other is that the hook is disengaged from the side wall of the socket 11 when the module 20 is unlocked. To engage the hook with the side wall of the socket 11, during installation of the tongue 25, the hook on the tongue 25 extends outside the casing 23 to engage with the side wall of the socket 11. For ease of exposing the hook, during installation of the casing 23, a through hole 231 that coordinates with the hook is disposed in the casing 23. When the hook of the tongue 25 is engaged with the side wall of the socket 11, specific force is required to make the hook and the side wall of the socket 11 keep in an engaged state. Therefore, the elastic component is disposed as a driving piece in the locking apparatus provided in the embodiments of this application, and the elastic component is configured to push the tongue 25 to rotate, and provide the force for making the hook on the tongue 25 engage with the side wall of the socket 11. The ejector lever 24 in the moving components serves as an unlocking component. The ejector lever 24 is rotatably connected to the supporting base 27, and is configured to press the tongue 25. When pressing against the tongue 25, the ejector lever 24 overcomes elastic force of the elastic component and pushes the tongue 25 to rotate, to disengage the hook from the side wall of the socket 11. During locking, the ejector lever 24 is out of contact with the tongue 25, so that the elastic component can push the tongue 25 to rotate and engage with the side wall of the socket 11. It can be learned from the foregoing description that, in the locking apparatus provided in the embodiments of this application, the elastic component is used to push the hook to lock the module 20 and the cabinet 10 together, and to implement unlocking, only the ejector lever 24 needs to be pulled to press the hook down. The operations are simple: Only the ejector lever 24 needs to be pulled to implement unlocking, and the module 20 is pushed into the cabinet 10 to implement locking. In addition, when this structure is used, as shown in FIG. 5, the tongue 25, the elastic component, and the ejector lever 24 are all disposed on the side wall of the module 20, and only a part of the ejector lever 24 is exposed out of a panel 22 of the module 20. Compared with a locking structure for a module 20 in the prior art, in this structure, an area occupied on the panel 22 is reduced.

It can be learned from the foregoing description that the locking apparatus for the module 20 provided in the embodiments of this application mainly implements locking and unlocking by using several moving components. The following describes in detail coordination between the several moving components with reference to the accompanying drawings. For ease of description, the following description is provided by using an example in which the elastic component is an elastic sheet 26.

First, FIG. 6 is referred to. FIG. 6 is a schematic exploded view of the supporting base 27 and the casing 23 of the locking module 20. It can be seen from FIG. 6 that the casing 23 covers the supporting base 27, and space for accommodating the moving components may be formed between the supporting base 27 and the casing 23. Both FIG. 6 and FIG. 7 are referred to. FIG. 7 shows a status when the moving components are assembled on the supporting base 27. After the moving components shown in FIG. 7 are assembled on the supporting base 27, as shown in FIG. 6, the casing 23 is covered on the supporting base 27, and is fastened onto the supporting base 27 by using a bolt, so that the moving components are restricted inside the space between the supporting base 27 and the casing 23.

Both FIG. 8 and FIG. 9 are referred to. FIG. 8 is a schematic exploded view of the moving components and the supporting base 27. FIG. 9 is a schematic structural diagram of the supporting base 27. In this application, the supporting base 27 is configured to support the tongue 25, the elastic component, and the ejector lever 24. To support the foregoing several moving components, a specific structure is disposed on the supporting base 27 to coordinate with different components. As shown in FIG. 9, a first groove 271 for accommodating the tongue 25 and the elastic sheet 26 is disposed in the supporting base 27. One end of the first groove 271 is connected to a second groove 272 that has an arc-shaped cross section. The second groove 272 is configured to coordinate with a rotating shaft of the tongue 25. When the casing 23 is covered on the supporting base 27, the second groove 272 and the casing 23 form a spatial structure that restricts the rotating shaft of the tongue 25. In addition, a side wall of the first groove 271 also serves as a structure for fixing the elastic sheet 26, and a protrusion 274 for rotatably coordinating with the ejector lever 24 is further disposed on the supporting base 27. To facilitate understanding of the foregoing structure, the following describes in detail a specific use of the foregoing structure on the supporting base 27 with reference to several specific moving components.

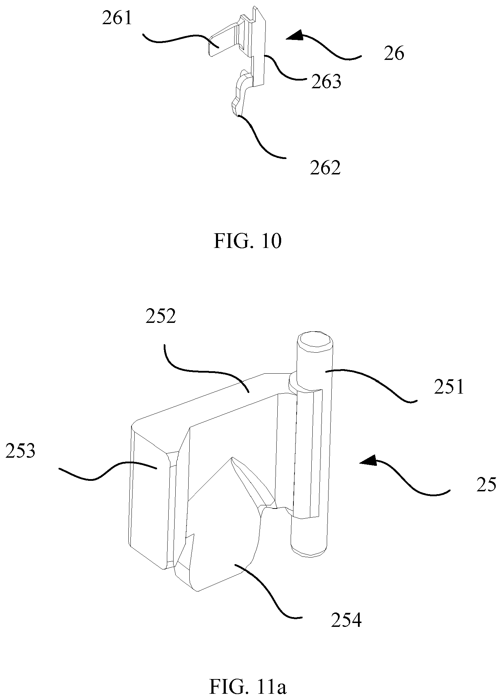

FIG. 8 to FIG. 1 are referred to. FIG. 10 is a schematic structural diagram of the elastic sheet 26. As shown in FIG. 10, the elastic sheet 26 serves as a moving component that pushes the tongue 25 to rotate and enables the hook on the tongue 25 to engage with the cabinet 10. When being disposed in the first groove 271 on the supporting base 27, as shown in FIG. 8, the elastic sheet 26 and the tongue 25 are stacked in the first groove 271 in a Z direction (a direction perpendicular to a surface that is of the supporting base 27 and on which the moving components are disposed) shown in FIG. 8. The elastic sheet 26 is located under the tongue 25, so that the elastic sheet 26 can push the tongue 25 towards a surface of the first groove 271, and further push the tongue 25 to rotate out of the first groove 271, to engage with a side wall of the cabinet 10. Still referring to FIG. 10, the elastic sheet 26 is a Z-shaped structure as a whole, and one end of the elastic sheet 26 is a fixed end, and the other end thereof is a free end. The fixed end is a bent structure 263 at an end of the elastic sheet 26. The bent structure 263 is an inverted L-shaped bent structure 263, configured to be attached to the side wall of the first groove 271. The side wall of the first groove 271 is a side wall adjacent to the second groove 272, and serves as a mounting base 273 to limit the elastic sheet 26. When the bent structure 263 of the elastic sheet 26 is attached onto the mounting base 273 and the casing 23 is covered on the supporting base 27, the mounting base 273 and the casing 23 are used to clamp the bent structure 263 of the elastic sheet 26, so that the elastic sheet 26 is fixed. Still referring to FIG. 10, it can be seen from FIG. 10 that the free end of the elastic sheet 26 is located on a plate-like structure. The plate-like structure should be an elastic plate 261, and the elastic plate 261 is connected to the inverted L-shaped bent structure 263 such that the entire elastic sheet 26 is Z-shaped. In addition, during specific installation, the elastic plate 261 may be an arc-shaped plate or a flat plate 22. Specifically, when the elastic plate 261 is arc-shaped, an inner concave surface of the elastic plate 261 may face the tongue 25 or may face away from the tongue 25; when the elastic sheet 261 is the flat plate 22, a vertical section, relative to the bent structure 263, of the flat plate 22 is disposed in an inclined manner, so that the free end can press against the tongue 25 to push the tongue 25 to rotate outwards (outside the groove). In addition, to improve structural strength of the elastic sheet 26, the bent structure 263 and the elastic plate 261 of the elastic sheet 26 are of an integrated structure, and are made of a material having specific elasticity, such as a common material with an elastic deformation property, for example, a stainless steel plate, a copper plate, or plastics. It should be understood that the elastic sheet 26 shown in FIG. 10 is merely a specific embodiment of the elastic component provided in the embodiments of this application. The elastic component provided in the embodiments of this application may be alternatively an elastic component of a different structure type. For example, the elastic component is a rotary spring. The rotary spring is sleeved on the rotating shaft of the tongue 25, and two ends of the rotary spring press against the supporting base 27 and a connecting plate, respectively, to push the tongue 25 to rotate and provide force for the hook to engage with the cabinet 10. Alternatively, the elastic component may be a common elastic component such as a compression spring or a rubber spring.

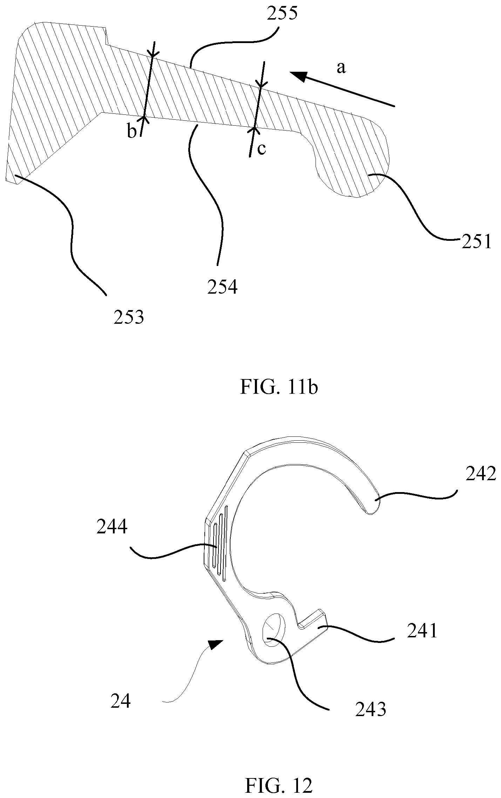

FIG. 8, FIG. 9, FIG. 11a, and FIG. 11b are referred to. FIG. 11a and FIG. 11b show a structure and a sectional view of the tongue 25, respectively. First, FIG. 8 is referred to. It can be seen from FIG. 8 that, during installation of the tongue 25, the tongue 25 is installed in the first groove 271 of the supporting base 27. For details, refer to the foregoing description of the supporting base 27 with reference to FIG. 9. The first groove 271 and the second groove 272 are disposed in the supporting base 27 for coordination with the tongue 25. A corresponding structure of the tongue 25 is shown in FIG. 11a. The tongue 25 includes a rotating shaft 251 and a connecting plate 252 connected to the rotating shaft 251. The rotating shaft 251 is configured to rotatably connect to the supporting base 27. A hook 253 is disposed at an end of the connecting plate 252 away from the rotating shaft 251 to engage with the side wall of the cabinet 10. During specific installation, as shown in FIG. 7 and FIG. 8, when the tongue 25 is assembled onto the supporting base 27, the rotating shaft 251 is located in the second groove 272, and there is a gap between the rotating shaft 251 and the side wall of the first groove 271 to accommodate the bent structure of the elastic sheet 26. In addition, the connecting plate 252 is located in the first groove 271 and presses against the elastic plate of the elastic sheet 26. When the casing 23 is covered on the supporting base, space for accommodating the rotating shaft 251 is enclosed by the second groove 272 and the casing 23 together, so that rotation stability of the tongue 25 can be kept when the rotating shaft 251 rotates. In addition, to improve structural strength of the entire tongue 25, the rotating shaft 251, the connecting plate 252, and the hook 253 are of an integrated structure, and the tongue 25 is made of a material having specific structural strength, such as stainless steel, copper, iron, or plastics. In addition, the tongue 25 may be fabricated through injection molding or stamping.

Still referring to FIG. 11a, in addition to the rotating shaft 251, the connecting plate, and the hook 253 described above, some structures for helping the ejector lever 24 to drive the tongue 25 to rotate are further disposed on the tongue 25, for example, a pressing surface 254 disposed on the connecting plate 252. Both FIG. 11a and FIG. 11b are referred to. FIG. 11b is a schematic diagram of a cross section that is of the connecting plate and that is perpendicular to a lengthwise direction of the rotating shaft 251. The pressing surface 254 is disposed on a surface, facing away from the supporting base 27, of the connecting plate 252. The pressing surface 254 is a surface pressed when the ejector lever 24 pushes the tongue 25 to rotate, and the pressing surface 254 is disposed in an inclined manner opposite to a first surface 255, facing the supporting base 27, of the connecting plate 252. As shown in FIG. 11b, in a direction away from the rotating shaft 251 (a direction a shown in FIG. 11b), a vertical distance between the pressing surface 254 and the first surface 255 gradually increases. As shown in FIG. 11b, a distance between the pressing surface 254 and a side that is of the first surface 255 and that is close to the rotating shaft 251 is c, a distance between the pressing surface 254 and a side that is of the first surface 255 and that is away from the rotating shaft 251 is b, and b > c. In this way, the entire connecting plate 252 becomes a structure in which the end provided with the hook 253 is relatively thick and an end connected to the rotating shaft 251 is relatively thin. In this implementation, when the ejector lever 24 presses the tongue 25, the ejector lever 24 first presses the connecting plate 252 from the side near the rotating shaft 251; and as the ejector lever 24 rotates, a pressing position of the ejector lever 24 on the connecting plate 252 gradually moves away from the rotating shaft 251. In a process in which the ejector lever 24 rotates, a thickness of a pressed section of the connecting plate 252 gradually increases. In this way, when the ejector lever 24 rotates by a relatively small range, the connecting plate 252 can rotate by a relatively large range, so that a movement range of the hook 253 is increased, and the hook 253 can be quickly unlocked from the side wall of the cabinet 10. During specific installation of the pressing surface 254, the pressing surface 254 may be connected to the surface, facing away from the supporting base 27, of the connecting plate. In this case, the cross section that is of the connecting plate and that is perpendicular to the direction of the rotating shaft 251 is a triangle-like cross section. In addition, the pressing surface 254 may alternatively be some structures formed on the surface, facing away from the supporting base 27, of the connecting plate. As shown in FIG. 11a, the pressing surface 254 is a pressing surface 254 that satisfies a requirement and that is formed by forming a notch on the surface, facing away from the supporting base 27, of the connecting plate. In addition, referring to FIG. 7 and FIG. 11a, to enable the pressing surface 254 to be closer to the ejector lever 24, a protrusion is disposed on a side, facing the ejector lever 24, of the connecting plate 252, and the protrusion and the connecting plate 252 are of an integrated structure. In this case, the pressing surface 254 is located on the protrusion and the connecting plate 252.

Still referring to FIG. 11b, in the hook provided in the embodiments of this application, a cross section of the hook is a right-angled triangular structure, and during inserting the module 20 into the socket 11, a surface, facing the socket 11, of the hook is an oblique surface, and a surface, facing away from the socket 11, of the hook is a right-angled surface. In this way, when the module 20 is pushed into the socket 11, the side wall of the socket 11 can press the hook to push the entire module 20 into the socket 11.

It should be understood that FIG. 11b shows only a specific implementation of the pressing surface 254, and another implementation may be alternatively used to improve a pressing effect generated when the ejector lever 24 presses the tongue 25. If the pressing surface 254 is a surface on which a part is a spiral surface, a rotating shaft around which the spiral surface extends is the rotating shaft around which the ejector lever 24 rotates.

The ejector lever 24 provided in the embodiments of this application serves as a driving piece. When being used, the ejector lever 24 presses against the tongue 25 during rotation, so that the hook on the tongue 25 can be unlocked from the cabinet 10. FIG. 8, FIG. 9, and FIG. 12 are referred to. FIG. 12 is a schematic structural diagram of the ejector lever 24 according to the embodiments of this application. In a structure shown in FIG. 12, the ejector lever 24 has two ends: a first end 241 and a second end 242. The first end 241 is a pressing end that coordinates with the tongue 25, and the second end 242 is an end opposite to the first end 241, and serves as a force applying end. During unlocking, the force applying end is pressed, so that the ejector lever 24 rotates; and when the pressing end presses against the tongue 25, the tongue 25 is driven to overcome elastic force of the elastic sheet 26 and rotate. The ejector lever 24 is a C-shaped ejector lever 24, and a rotating shaft hole 243 is disposed in a side that is of the ejector lever 24 and that is close to the first end 241. With reference to the structure shown in FIG. 9, the protrusion 274 that coordinates with the rotating shaft hole 243 is disposed on the supporting base 27. The protrusion 274 serves as a rotating shaft. During assembly of the ejector lever 24, the protrusion 274 is inserted into the rotating shaft hole 243; and a threaded hole is disposed in the protrusion 274, and the threaded hole locks the casing 23 and the supporting base 27 together through coordination with a bolt or a screw. In addition, to reduce friction of the ejector lever 24 during rotation, a bearing that can rotate relative to the protrusion 274 is sleeved on the protrusion 274, and the bearing is inserted into the rotating shaft hole 243.

Still referring to FIG. 9, a notch that coordinates with the C-shaped ejector lever 24 is further disposed on the supporting base 27, and the notch is divided into two parts: a first notch and a second notch. The first notch and the second notch are arranged on two opposite sides of the first groove 271, and are configured to accommodate the two ends of the ejector lever 24. During assembly of the ejector lever 24 on the supporting base 27, as shown in FIG. 7, the first end 241 of the ejector lever 24 is located in the first notch, the second end 242 of the ejector lever 24 is located in the second notch, and a middle part of the ejector lever 24 is exposed outside a side face that is of the supporting base 27 and that is perpendicular to the casing 23, for facilitate pulling of the ejector lever 24. In addition, to more conveniently pull the ejector lever 24 to rotate, an antiskid protrusion 244 is disposed on the part, exposed outside the supporting base 27, of the ejector lever 24, so that the second end 242 of the ejector lever 24 is pulled out of the second notch. During installation of the entire locking apparatus on the module 20, the locking apparatus is installed on the side wall of the module 20. In this case, the ejector lever 24 is exposed outside a surface of the panel 22 of the module 20, and only the ejector lever 24 of the entire locking apparatus is exposed on the panel 22. Therefore, compared with the prior-art structure shown in FIG. 3, in this structure, an occupied area on the panel 22 can be reduced, and utilization of the panel 22 can be improved.

In addition, to ensure that the ejector lever 24 can keep a stable posture when not pressing the tongue 25, referring to both FIG. 10 and FIG. 12, an elastic protrusion 262 that coordinates with the first end 241 of the ejector lever 24 is disposed on the elastic sheet 26. The elastic protrusion 262 is a bent elastic protrusion 262, and the elastic protrusion 262 and the elastic sheet 26 are of an integrated structure. To ensure that the ejector lever 24 can be locked when not being used, when the ejector lever 24 is rotated to a second specified position, the ejector lever 24 engages with the elastic protrusion 262.In the second specified position, the ejector lever 24 does not press the tongue 25. In this case, the second end 242 is located in the second notch, and the first end 241 presses against the elastic protrusion 262, so that the ejector lever 24 can keep a stable posture. When the ejector lever 24 needs to be pulled, the first end 241 overcomes force of the elastic protrusion 262 and rotates.

Still referring to FIG. 6, it can be seen from the structure shown in FIG. 6 that a rotation direction of the ejector lever 24 is perpendicular to a rotation direction of the tongue 25. The ejector lever 24 is used to press the tongue 25 to change the rotation direction of the ejector lever 24 to the moving direction of the tongue 25, to unlock the tongue 25 from the side wall of the cabinet 10. Certainly, during specific installation, the rotating shaft around which the ejector lever 24 rotates may not be completely perpendicular to the rotating shaft around which the tongue 25 rotates, and a specific inclination angle may exist between the rotating shafts, but an application principle is the same as a principle of the structure shown in FIG. 6 in the embodiments of this application, and there is no substantial difference between the principles.

To facilitate understanding of an operating principle of the locking apparatus provided in the embodiments of this application, the following provides a detailed description with reference to the accompanying drawings. For ease of describing the principle, the locking apparatus provided in the embodiments of this application is installed on the module 20. As shown in FIG. 5, the module 20 includes a module body 21, the locking apparatus, and the panel 22. The locking apparatus is located on the side wall of the module body 21, and the outer casing of the module body 21 covers the side wall of the module body 21, the panel 22 covers ends of the module body 21, and correspondingly, the through hole that coordinates with the ejector lever 24 is disposed in the panel 22, so that the ejector lever 24 is exposed out of the panel 22. To ensure structure compactness, the supporting base 27 of the locking apparatus and the side wall of the module body 21 are of an integrated structure, and the casing 23 of the locking module 20 and the outer casing of the module body 21 are of an integrated structure.

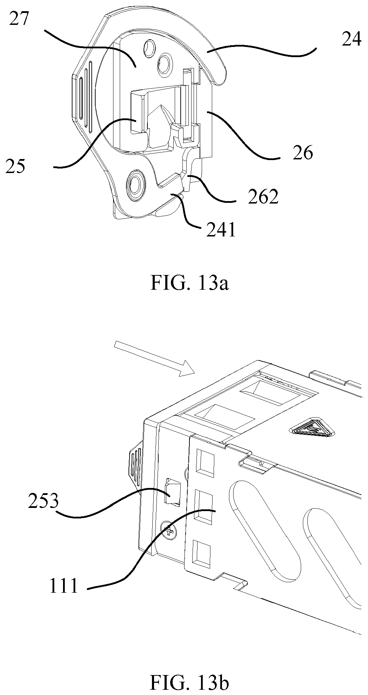

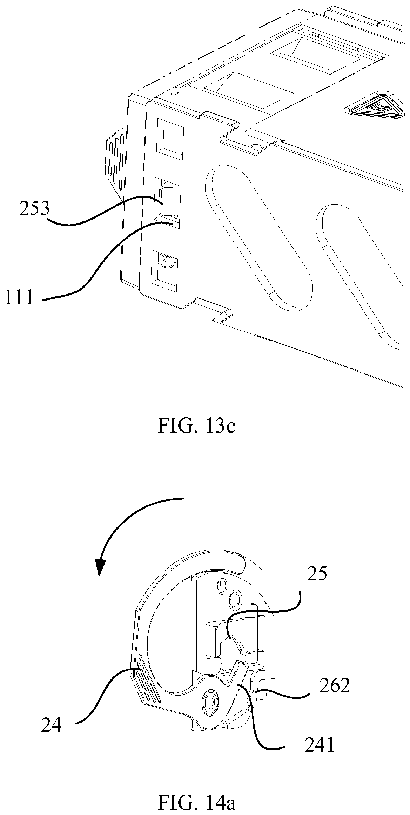

First, FIG. 13a to FIG. 13c are referred to. FIG. 13a shows position status of the moving components of the locking structure. In these position status, the ejector lever is rotated to the second specified position, and the ejector lever 24 does not press against the tongue 25. In this case, the tongue 25 is pushed by the elastic sheet 26 to press against the outer casing of the module 20, and the hook on the tongue 25 passes through the through hole 231 of the outer casing and then is exposed outside the casing 23. Both FIG. 13b and FIG. 13c are referred to. First, as shown in FIG. 13b, the slot 111 that coordinates with the hook is disposed in the side wall of the socket 11, and when the module 20 is inserted into the socket 11, the module 20 is pushed in a direction indicated by a straight line with an arrow shown in FIG. 13b. Because the surface, facing the socket 11, of the hook that is an oblique surface, the hook moves back into the through hole 231 when being pressed by the side wall of the socket 11; and when the module 20 moves in place, the slot 111 in the side wall of the socket 11 is opposite to a position of the hook. At this time, under action of the elastic sheet 26, the hook bounces and engages with the slot 111. When the module 20 is pulled outwards, a vertical side wall of the hook presses against the slot 111, so that the module 20 is tightly locked in the socket 11.

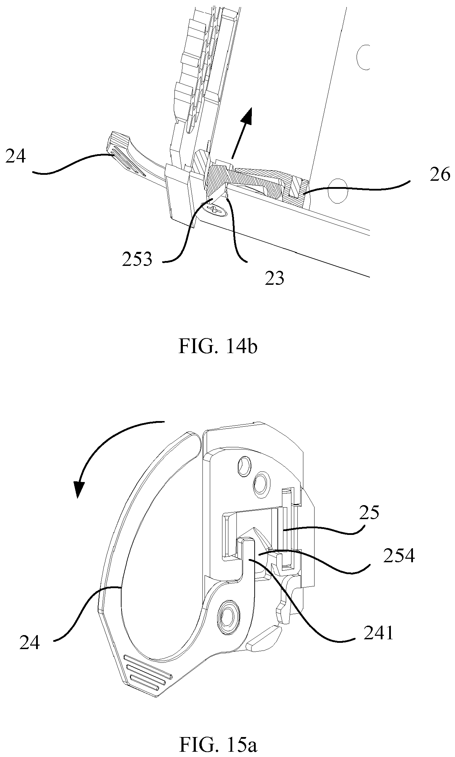

Both FIG. 14a and FIG. 14b are referred to. FIG. 14a shows a coordination status of the moving components of the locking module 20. FIG. 14b shows a status of the corresponding module 20 in the socket 11. As shown in FIG. 14a, when the socket 11 needs to be pulled out, the ejector lever 24 is rotated in a direction indicated by an arrow shown in FIG. 14a, the first end of the ejector lever 24 starts to press against the pressing surface on the tongue 25 and drive the tongue 25 to rotate. As shown in FIG. 14b, the hook starts to rotate in a direction indicated by an arrow shown in FIG. 14b, to move back into the through hole 231.

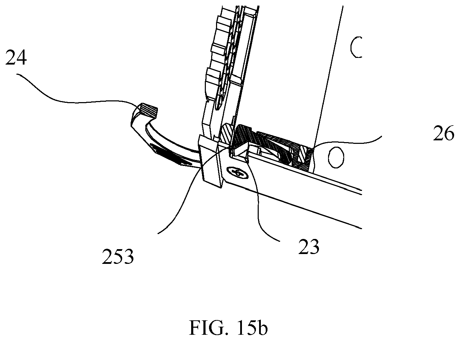

Both FIG. 15a and FIG. 15b are referred to. FIG. 15a shows a coordination status of the moving components of the locking module 20. FIG. 15b shows a status of the corresponding module 20 in the socket 11. First, as shown in FIG. 15a, the ejector lever 24 continues being rotated in a direction indicated by an arrow in FIG. 15a, so that the first end of the ejector lever 24 continues pressing the tongue 25, and the tongue 25 continues rotating to a status shown in FIG. 15b. At this time, the ejector lever is rotated to the first specified position, and the hook completely moves back into the through hole 231.

Still referring to FIG. 5, the embodiments of this application further provide a module 20. The module 20 includes the module body 21, the locking apparatus, and the panel 22. The locking apparatus is located on the side wall of the module body 21, and the outer casing of the module body 21 covers the side wall of the module body 21, the panel 22 covers ends of the module body 21, and correspondingly, the through hole that coordinates with the ejector lever 24 is disposed in the panel 22, so that the ejector lever 24 is exposed out of the panel 22. To ensure structure compactness, the supporting base 27 of the locking apparatus and the side wall of the module body 21 are of an integrated structure, and the casing 23 of the locking module 20 and the outer casing of the module body 21 are of an integrated structure. In this embodiment, the elastic component is used to push the hook to lock the module 20 and the cabinet 10 together, and to implement unlocking, only the ejector lever 24 needs to be pulled to press the hook down. It can be learned from the foregoing description that the operations during using of the locking apparatus for the module 20 provided in the present application are simple: Only the ejector lever 24 needs to be pulled to implement unlocking, and the module 20 is pushed into the cabinet 10 to implement locking. In addition, when this structure is used, the tongue 25, the elastic component, and the ejector lever 24 are all disposed on the side wall of the module 20, and only a part of the ejector lever 24 is exposed out of the panel 22 of the module 20. Compared with a locking structure for a module 20 in the prior art, in this structure, an area occupied on the panel 22 is reduced.

Still referring to FIG. 4, the embodiments of this application further provide electrical equipment. The electrical equipment includes the cabinet 10 and the foregoing module 20 inserted into the cabinet 10. The slot 111 that coordinates with the hook is disposed in the cabinet 10. During specific installation, the socket 11 in one-to-one correspondence with the module 20 is disposed in each cabinet 10, and the slot 111 that coordinates with the hook is disposed in the socket 11. When the module 20 is used, the elastic component of the locking apparatus on the module 20 is used to push the hook to lock the module 20 and the cabinet 10 together, and to implement unlocking, only the ejector lever 24 needs to be pulled to press the hook down. It can be learned from the foregoing description that the operations during using of the locking apparatus for the module 20 provided in the present application are simple: Only the ejector lever 24 needs to be pulled to implement unlocking, and the module 20 is pushed into the cabinet 10 to implement locking. In addition, when this structure is used, the tongue 25, the elastic component, and the ejector lever 24 are all disposed on the side wall of the module 20, and only a part of the ejector lever 24 is exposed out of the panel 22 of the module 20. Compared with a locking structure for a module 20 in the prior art, in this structure, an area occupied on the panel 22 is reduced.

The foregoing descriptions are merely specific implementations of the present application, but are not intended to limit the protection scope of the present application. The protection scope of the present application shall be subject to the protection scope of the claims.

## Claims

1. A module locking apparatus, configured to be fixedly connected to the module body (21) of a module (20) and configured to lock the module (20) onto a cabinet (10), wherein the module locking apparatus comprises a supporting base (27) and a casing (23) that covers the supporting base, and further comprises an ejector lever (24), a tongue (25), and an elastic component (26), wherein
the tongue is located between the supporting base and the casing; one end of the tongue is rotatably connected to the supporting base, and the other end of the tongue is a free end; and a hook (253) configured to engage with the cabinet is disposed on the free end and the tongue (25) has two working statuses when being rotated: one is that the hook is engaged with the cabinet when the module (20) is locked, and the other is that the hook is disengaged from the cabinet when the module (20) is unlocked;
the elastic component (26) is disposed as a driving piece in the locking apparatus and is configured to drive the hook to be exposed out of the casing and engage with the cabinet; and
the ejector lever (24) serves as an unlocking component and is rotatably connected to the supporting base and is configured to press the tongue;
during locking the ejector lever is out of contact with the tongue, so that the elastic component can push the tongue to rotate and engage with the cabinet, and when being rotated to a first specified position, the ejector lever presses the tongue to rotate to a position in which the tongue is disengaged from the cabinet.

2. The module locking apparatus according to claim 1, wherein the tongue comprises a rotating shaft rotatably connected to the supporting base and a connecting plate (252) connected to the rotating shaft, wherein the hook is disposed at an end of the connecting plate away from the rotating shaft.

3. The module locking apparatus according to claim 2, wherein the elastic component is a rotary spring, the rotary spring is sleeved on the rotating shaft, and two ends of the rotary spring press against the supporting base and the connecting plate, respectively.

4. The module locking apparatus according to claim 2, wherein
a mounting base is disposed on the supporting base; and
the elastic component is an elastic sheet; one end of the elastic sheet is provided with a bent structure clamped on the mounting base, and the other end of the elastic sheet is a free end; and the free end of the elastic sheet presses against a surface, facing the supporting base, of the connecting plate.

5. The module locking apparatus according to claim 4, wherein the bent structure is connected to an elastic protrusion that coordinates with the ejector lever; and
when the ejector lever is rotated to a second specified position, the ejector lever disengages from the tongue, and the ejector lever engages with the elastic protrusion.

6. The module locking apparatus according to any one of claims 2 to 5, wherein a surface, facing away from the supporting base, of the connecting plate is a pressing surface that coordinates with the ejector lever; the pressing surface is disposed in an inclined manner opposite to a first surface, facing the supporting base, of the connecting plate; and a vertical distance between the pressing surface and the first surface gradually increases in a direction away from the rotating shaft.

7. The module locking apparatus according to claim 6, wherein the ejector lever is a C-shaped ejector lever, and two ends of the ejector lever are a first end and a second end, respectively, wherein the first end is used for pressing the pressing surface; and
a notch for accommodating the first end and the second end is disposed on the supporting base, and when the ejector lever is rotated to the second specified position, both the first end and the second end of the ejector lever are located in the notch, and a middle part of the ejector lever is exposed outside a side face that is of the supporting base and that is perpendicular to the casing.

8. The module locking apparatus according to claim 7, wherein an antiskid protrusion is disposed on the middle part of the ejector lever.

9. The module locking apparatus according to claim 1, wherein a rotation direction of the ejector lever is perpendicular to a rotation direction of the tongue.

10. The module locking apparatus according to claim 1, wherein a through hole that coordinates with the hook is disposed in the casing.

11. A module, comprising a module body (21) and the locking apparatus, according to any one of claims 1 to 10, fixedly connected to the module body.

12. The module according to claim 11, further comprising an outer casing covering the module body, wherein the supporting base and a side wall of the module body are of an integrated structure, and the casing and the outer casing of the module body are of an integrated structure.

13. Electrical equipment, comprising a cabinet and the module, according to claim 11 or 12, inserted into the cabinet, wherein a slot that coordinates with the hook is disposed in the cabinet.

## Patentansprüche

1. Modulverriegelungsvorrichtung, die konfiguriert ist, um fest mit dem Modulkörper (21) eines Moduls (20) verbunden zu werden und konfiguriert ist, um das Modul (20) in einem Schrank (10) zu verriegeln, wobei die Modulverriegelungsvorrichtung eine Stützbasis (27) und ein Gehäuse (23) umfasst, das die Stützbasis abdeckt, und ferner einen Auswerferhebel (24), eine Zunge (25) und eine elastische Komponente (26) umfasst, wobei
die Zunge sich zwischen der Stützbasis und dem Gehäuse befindet; ein Ende der Zunge drehbar mit der Stützbasis verbunden ist und das andere Ende der Zunge ein freies Ende ist; und am freien Ende ein Haken (253) angeordnet ist, der konfiguriert ist, um mit dem Schrank in Eingriff zu kommen, und die Zunge (25) beim Drehen zwei Arbeitszustände aufweist: der eine besteht darin, dass der Haken mit dem Schrank in Eingriff steht, wenn das Modul (20) verriegelt ist, und der andere besteht darin, dass der Haken vom Schrank gelöst ist, wenn das Modul (20) entriegelt ist;
die elastische Komponente (26) als Antriebsteil in der Verriegelungsvorrichtung angeordnet und konfiguriert ist, um den Haken so zutreiben, dass er aus dem Gehäuse freigelegt wird und mit dem Schrank in Eingriff kommt; und
der Auswerferhebel (24) als Entriegelungskomponente dient und drehbar mit der Stützbasis verbunden und zum Drücken der Zunge konfiguriert ist;
während des Verriegelns der Auswerferhebel keinen Kontakt mit der Zunge hat, sodass die elastische Komponente die Zunge zum Drehen drücken und mit dem Schrank in Eingriff bringen kann, und wenn der Auswerferhebel in eine erste festgelegte Position gedreht wird, er auf die Zunge drückt, um sie in eine Position zu drehen, in der die Zunge vom Schrank gelöst ist.

2. Modulverriegelungsvorrichtung nach Anspruch 1, wobei die Zunge eine drehbar mit der Stützbasis verbundene Drehwelle und eine mit der Drehwelle verbundene Verbindungsplatte (252) umfasst, wobei der Haken an einem von der Drehwelle entfernten Ende der Verbindungsplatte angeordnet ist.

3. Modulverriegelungsvorrichtung nach Anspruch 2, wobei die elastische Komponente eine Drehfeder ist, die Drehfeder auf der Drehwelle aufgesteckt ist und zwei Enden der Drehfeder jeweils gegen die Stützbasis und die Verbindungsplatte drücken.

4. Modulverriegelungsvorrichtung nach Anspruch 2, wobei eine Montagebasis auf der Stützbasis angeordnet ist; und
die elastische Komponente eine elastische Folie ist; ein Ende der elastischen Folie mit einer gebogenen Struktur versehen ist, die an der Montagebasis festgeklemmt ist, und das andere Ende der elastischen Folie ein freies Ende ist; und das freie Ende der elastischen Folie gegen eine der Stützbasis zugewandte Fläche der Verbindungsplatte drückt.

5. Modulverriegelungsvorrichtung nach Anspruch 4, wobei die gebogene Struktur mit einem elastischen Vorsprung verbunden ist, der mit dem Auswerferhebel abgestimmt ist; und
wenn der Auswerferhebel in eine zweite festgelegte Position gedreht wird, sich der Auswerferhebel von der Zunge löst und der Auswerferhebel in den elastischen Vorsprung eingreift.

6. Modulverriegelungsvorrichtung nach einem der Ansprüche 2 bis 5, wobei eine von der Stützbasis abgewandte Fläche der Verbindungsplatte eine mit dem Auswerferhebel abgestimmte Druckfläche ist; die Druckfläche geneigt gegenüber einer ersten, der Stützbasis zugewandten Fläche der Verbindungsplatte angeordnet ist; und ein vertikaler Abstand zwischen der Druckfläche und der ersten Fläche in einer Richtung weg von der Drehwelle allmählich zunimmt.

7. Modulverriegelungsvorrichtung nach Anspruch 6, wobei der Auswerferhebel ein C-förmiger Auswerferhebel ist und zwei Enden des Auswerferhebels jeweils ein erstes Ende und ein zweites Ende sind, wobei das erste Ende zum Drücken der Druckfläche verwendet wird; und
eine Aussparung zum Aufnehmen des ersten Endes und des zweiten Endes auf der Stützbasis angeordnet ist, und wenn der Auswerferhebel in die zweite festgelegte Position gedreht wird, sich sowohl das erste Ende als auch das zweite Ende des Auswerferhebels in der Aussparung befinden und ein mittlerer Teil des Auswerferhebels außerhalb einer Seitenfläche der Stützbasis frei liegt, die senkrecht zum Gehäuse verläuft.

8. Modulverriegelungsvorrichtung nach Anspruch 7, wobei am mittleren Teil des Auswerferhebels ein rutschsicherer Vorsprung angeordnet ist.

9. Modulverriegelungsvorrichtung nach Anspruch 1, wobei eine Drehrichtung des Auswerferhebels senkrecht zu einer Drehrichtung der Zunge ist.

10. Modulverriegelungsvorrichtung nach Anspruch 1, wobei im Gehäuse ein Durchgangsloch angeordnet ist, das mit dem Haken abgestimmt ist.

11. Modul, umfassend einen Modulkörper (21) und die fest mit dem Modulkörper verbundene Verriegelungsvorrichtung nach einem der Ansprüche 1 bis 10.

12. Modul nach Anspruch 11, ferner umfassend ein Außengehäuse, das den Modulkörper abdeckt, wobei die Stützbasis und eine Seitenwand des Modulkörpers eine integrierte Struktur aufweisen und das Gehäuse und das Außengehäuse des Modulkörpers eine integrierte Struktur aufweisen.

13. Elektrische Ausrüstung, umfassend einen Schrank und das in den Schrank eingesetzte Modul nach Anspruch 11 oder 12, wobei im Schrank ein Schlitz angeordnet ist, der mit dem Haken abgestimmt ist.

## Revendications

1. Appareil de verrouillage de module, configuré pour être relié de manière fixe au corps de module (21) d'un module (20) et configuré pour verrouiller le module (20) sur une armoire (10), dans lequel l'appareil de verrouillage de module comprend une base de support (27) et un boîtier (23) qui recouvre la base de support, et comprend en outre un levier éjecteur (24), une languette (25) et un composant élastique (26), dans lequel
la languette est située entre la base de support et le boîtier ; une extrémité de la languette est reliée de manière rotative à la base de support, et l'autre extrémité de la languette est une extrémité libre ; et un crochet (253) configuré pour entrer en contact avec l'armoire est disposé sur l'extrémité libre et la languette (25) a deux états de fonctionnement lorsqu'elle est tournée : un est que le crochet est en contact avec l'armoire lorsque le module (20) est verrouillé, et l'autre est que le crochet est hors contact avec l'armoire lorsque le module (20) est déverrouillé ;
le composant élastique (26) est disposé en tant que pièce d'entraînement dans l'appareil de verrouillage et est configuré pour entraîner le crochet à s'exposer hors du boîtier et à entrer en contact avec l'armoire ; et
le levier éjecteur (24) sert de composant de déverrouillage et est relié de manière rotative à la base de support et est configuré pour appuyer sur la languette ;
pendant le verrouillage, le levier éjecteur n'est pas en contact avec la languette, de sorte que le composant élastique peut pousser la languette pour la faire tourner et entrer en contact avec l'armoire, et lorsqu'il est tourné vers une première position spécifiée, le levier éjecteur appuie sur la languette pour la faire tourner vers une position dans laquelle la languette est hors contacte avec l'armoire.

2. Appareil de verrouillage de module selon la revendication 1, dans lequel la languette comprend un axe de rotation relié de manière rotative à la base de support et une plaque de liaison (252) reliée à l'axe de rotation, dans lequel le crochet est disposé à une extrémité de la plaque de liaison à l'opposé de l'axe de rotation.

3. Appareil de verrouillage de module selon la revendication 2, dans lequel le composant élastique est un ressort rotatif, le ressort rotatif est emmanché sur l'axe rotation, et deux extrémités du ressort rotatif pressent contre la base de support et la plaque de liaison, respectivement.

4. Appareil de verrouillage de module selon la revendication 2, dans lequel :
une base de montage est disposée sur la base de support ; et
le composant élastique est une feuille élastique ; une extrémité de la feuille élastique est pourvue d'une structure coudée serrée sur la base de montage, et l'autre extrémité de la feuille élastique est une extrémité libre ; et l'extrémité libre de la feuille élastique appuie contre une surface, tournée vers la base de support, de la plaque de liaison.

5. Appareil de verrouillage de module selon la revendication 4, dans lequel la structure coudée est reliée à une saillie élastique qui se coordonne avec le levier éjecteur ; et
lorsque le levier éjecteur est tourné vers une seconde position spécifiée, le levier éjecteur sort du contact avec la languette, et le levier éjecteur entre en contact avec la saillie élastique.

6. Appareil de verrouillage de module selon l'une quelconque des revendications 2 à 5, dans lequel une surface, tournée à l'opposé de la base de support, de la plaque de liaison est une surface de pression qui se coordonne avec le levier éjecteur ; la surface de pression est disposée de manière inclinée à l'opposé d'une première surface, tournée vers la base de support, de la plaque de liaison ; et une distance verticale entre la surface de pression et la première surface augmente progressivement dans une direction s'éloignant de l'axe de rotation.

7. Appareil de verrouillage de module selon la revendication 6, dans lequel le levier éjecteur est un levier éjecteur en forme de C, et les deux extrémités du levier éjecteur sont une première extrémité et une seconde extrémité, respectivement, dans lequel la première extrémité est utilisée pour appuyer sur la surface de pression ; et
une encoche pour loger la première extrémité et la seconde extrémité est disposée sur la base de support, et lorsque le levier éjecteur est tourné vers la seconde position spécifiée, à la fois la première extrémité et la seconde extrémité du levier éjecteur sont situées dans l'encoche, et une partie médiane du levier éjecteur est exposée à l'extérieur d'une face latérale de la base de support et perpendiculaire au boîtier.

8. Appareil de verrouillage de module selon la revendication 7, dans lequel une saillie antidérapante est disposée sur la partie médiane du levier éjecteur.

9. Appareil de verrouillage de module selon la revendication 1, **caractérisé en ce qu'**un sens de rotation du levier éjecteur est perpendiculaire à un sens de rotation de la languette.

10. Appareil de verrouillage de module selon la revendication 1, dans lequel un trou traversant qui se coordonne avec le crochet est disposé dans le boîtier.

11. Module, comprenant un corps de module (21) et l'appareil de verrouillage, selon l'une quelconque des revendications 1 à 10, relié de manière fixe au corps de module.

12. Module selon la revendication 11, comprenant en outre un boîtier externe recouvrant le corps de module, dans lequel la base de support et une paroi latérale du corps de module sont d'une structure intégrée, et le boîtier et le boîtier externe du corps de module sont d'une structure intégrée.

13. Équipement électrique comprenant une armoire et le module, selon la revendication 11 ou 12, inséré dans l'armoire, dans lequel une fente qui se coordonne avec le crochet est disposée dans l'armoire.
